(19)

**Europäisches Patentamt**
**European Patent Office**
**Office européen des brevets**

(11) **EP 3 361 272 A1**

(12) **EUROPEAN PATENT APPLICATION**

(43) Date of publication:
**15.08.2018 Bulletin 2018/33**

(51) Int Cl.:
*G01R 27/16* *(2006.01)*    *G01R 31/42* *(2006.01)*
*G01R 31/34* *(2006.01)*    *G01R 19/25* *(2006.01)*
*G01R 31/08* *(2006.01)*

(21) Application number: **17155324.1**

(22) Date of filing: **09.02.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ABB Schweiz AG**
**5400 Baden (CH)**

(72) Inventors:
• ZHANG, Yan
 5400 Baden (CH)
• DZUNG, Dacfey
 5430 Wettingen (CH)

(74) Representative: **ABB Patent Attorneys**
**c/o ABB Schweiz AG**
**Intellectual Property CH-IP**
**Brown Boveri Strasse 6**
**5400 Baden (CH)**

(54) **GRID IMPEDANCE ESTIMATION BASED ON TOTAL LEAST SQUARES**

(57)    A method for estimating an equivalent impedance of an electrical grid (10) comprises: receiving a plurality of measurement values of a grid voltage $(V_{pcc}^{ti})$ and a grid current $(I_{pcc}^{ti})$, measured over a time interval at different time points; minimizing an objective function ($S$) based on the measurement values $(V_{pcc}^{ti}, I_{pcc}^{ti})$, a grid voltage parameter $(\tilde{X}_0)$, and parameters $(\tilde{X}_1)$ of the equivalent impedance, which objective function ($S$) comprises a length of an error vector ($\varepsilon$); and determining the equivalent impedance ($X_1$) by dividing the parameters of the equivalent impedance $(\tilde{X}_1)$ by the grid voltage parameter $(\tilde{X}_0)$. The error vector ($\varepsilon$) is composed of a grid voltage based vector $(V\tilde{X}_0)$ based on grid voltage measurements $(V_{pcc}^{ti})$ times the grid voltage parameter $(\tilde{X}_0)$ and a grid current based vector $(A_1\tilde{X}_1)$ based on grid current measurements $(I_{pcc}^{ti})$ times the parameters $(\tilde{X}_1)$ of the equivalent impedance.

**Fig. 3**

$$\varepsilon = V\tilde{X}_0 + A_1\tilde{X}_1 + A_2\tilde{X}_2$$

$$S = S(\|\varepsilon\|^2)$$

$$X_{1/2} = -\frac{1}{\tilde{X}_0}\tilde{X}_{1/2}$$

EP 3 361 272 A1

**Description**

FIELD OF THE INVENTION

The invention relates to a method for estimating an equivalent impedance of an electrical grid as well as to a controller for performing the method.

BACKGROUND OF THE INVENTION

Electrical impedance describes a measure of opposition to alternating current. In principle, the electrical impedance can be estimated by complex division of the measured voltage and current according to Ohm's law. Instead of a being constant value, the electrical impedance varies with time and frequency. The variations in the electrical impedance of a grid are mainly caused by faults in the network and/or variations in the load. For many controllers, protections and filter devices, it is beneficial to know the grid impedances in order to be able to operate reliably.

Various methods have been developed to estimate grid impedances at fundamental and harmonics frequencies. Invasive approaches apply external disturbances to the grid. The impedances are estimated based on the grid responses to the external disturbances. These types of approaches rely on external injections. It may be therefore difficult to perform online tracking of the impedance variations. It may also not desirable to inject disturbances to a running system considering the losses and reliability issues. Non-invasive approaches depend on natural load current and existing harmonics source variations. In these approaches, the lack of sufficient excitations and/or a considerable level of noises in the measured signals may be a problem.

The main step in both the invasive and non-invasive approaches may be to perform an estimation based on collected measurements in terms of voltage and current values. Least squares based estimation methods are widely applied, which basically deal with noise on the voltage measurements only.

The article of D. Ritzmann, P. Wright, W. Holderbaum, B. Potter, "Application and Analysis of Synchrophasor-based Online Impedance Measurement Methods", CIRED, 23rd International Conference on Electricity Distribution, Lyon, 15-18 June 2015, Paper 0834, describes how total least square may be used for impedance estimation in the frequency domain, in order to take into account noise on both voltage and current measurements.

DESCRIPTION OF THE INVENTION

It is an objective of the invention to provide a computational fast and accurate equivalent impedance estimation method.

This objective is achieved by the subject-matter of the independent claims. Further exemplary embodiments are evident from the dependent claims and the following description.

A first aspect of the invention relates to a method for estimating an equivalent impedance of an electrical grid. An electrical grid may be an electrical network that supplies a plurality of consumers with electrical power and/or that receives electrical power from a plurality of power sources.

The electrical grid may be modelled with an equivalent circuit that comprises an equivalent impedance and optionally an equivalent voltage source. The equivalent impedance may be parametrized as complex number and/or with a resistance value and an inductance value. The equivalent voltage source may be parametrized with an optional complex voltage value.

According to an embodiment of the invention, the method comprises: receiving a plurality of measurement values of grid voltage and grid current, measured over a time interval at different time points. The measurement values may be measured at a point of common coupling of an electrical device with the electrical grid. The measurement values may be measured during a measurement interval at different time point. For example, the measurement interval may comprise more than 100 different measurement values.

According to an embodiment of the invention, the method further comprises: minimizing an objective function based on the measurement values, based on a grid voltage parameter, and based on parameters of the equivalent impedance. The objective function comprises a length of an error vector, the error vector being composed of a grid voltage based vector, based on grid voltage measurements times the grid voltage parameter, and a grid current based vector, based on grid current measurements times the parameters of the equivalent impedance.

The error vector may be based on the sum of the grid voltage based vector and the grid current based vector. The grid voltage based vector may be a vector of the grid voltage measurements times the grid voltage parameter. The grid current based vector may be the sum of a vector of the grid current measurements times a parameter for an equivalent resistance and a vector of discrete derivatives of the grid current measurements times a parameter for an equivalent inductance.

By minimizing the objective function with respect to the grid voltage parameter and the parameters of the equivalent impedance, optionally under the constraint that the parameter vector has non-zero length, an optimal grid voltage parameter and optimal parameters of the equivalent impedance may be determined. From the optimal equivalent impedance (for example the equivalent resistance and the equivalent inductance), the estimated equivalent resistance may be determined.

Optionally, the objective function may comprise at least one parameter for an equivalent voltage source. The objective function may have been modelled such that an equivalent voltage source is considered. In the first case, the objective function also may be minimized with respect to the at least one parameter for the equivalent voltage source. In the second case, the objective function may be based on a more general objective function, which has been optimized analytically with respect to the at least one parameter for the equivalent voltage source. It may be that the equivalent impedance and the equivalent source voltage are estimated simultaneously using grid voltage measurements and grid current measurements.

While other methods only take into account the noise of one of the voltage and current measurements (typically noise of the grid voltage measurements at the point of common coupling, but not on the grid current measurements), the method deals with noise on both measurements. Hence, the estimation model may be closer to realistic scenarios and the estimation results may be more accurate.

It may be that the objective function is minimized with a total least squares method. Details of such a method are described below. In particular, with total least squares, both the error in the voltage measurements and the current measurements may be taken symmetrically into account.

According to an embodiment of the invention, the method further comprises: determining the equivalent impedance by dividing the parameters of the equivalent impedance by minus one times the grid voltage parameter. Since the objective function and in particular the error vector comprises an additional parameter for the grid voltage, the estimated equivalent impedance is a function of all optimization parameters and has to be calculated from all these parameters.

According to an embodiment of the invention, the objective function is a length of the error vector divided by a length of a parameter vector, the parameter vector being composed of the grid voltage parameter and the parameters of the equivalent impedance. Due to the structure of the objective function with a length of the error vector, also 0 may be an invalid optimal point of the parameter vector. To suppress this point, the length of the error vector may be divided by a length of the parameter vector.

According to an embodiment of the invention, the error vector additionally is composed of a source voltage vector modelling an equivalent source voltage of the grid, the source voltage vector being based on at least one source voltage parameter. This source voltage vector may take the separate source voltage, which may be part of the model of the grid, into account. For example, the source voltage vector may be the product of known and/or estimated harmonics of the source voltage with source voltage parameters.

It also may be that the objective function has been determined from the error vector by analytically minimizing with respect to at least one source voltage parameter. In other words, in a first step, a more general objective function based on the grid voltage based vector, the grid current based vector, and the source voltage vector, may be minimized analytically by minimization with respect to the at least one source voltage parameter. This first step results in an analytically minimized objective function that may be minimized numerically in a second step to determine the optimal grid voltage parameter and the optimal parameters of the equivalent impedance.

In general, the error vector may be the sum of the grid voltage based vector, the grid current based vector and optionally the source voltage vector. The objective function may be a length of this error vector optionally divided by a length of the above mentioned parameter vector.

According to an embodiment of the invention, the objective function is minimized with a (time) recursive least square algorithm, which may be a total least square algorithm. In this context, "recursive" or "time recursive" may mean that the minimization algorithm uses results, which have been determined at previous time points. In particular, at a first time point, the objective function may be minimized to determine the optimal grid voltage parameter and the optimal parameters of the equivalent impedance for the first time point. Later at a second time point, for example the next time point, the objective function may be minimized to determine the optimal grid voltage parameter and the optimal parameters of the equivalent impedance for the second time point. The calculations at the second time point may be based on different measurements of the grid voltage and the grid currents. However, there may be an overlapping measurement interval. During the calculation for the second time point, results that have been determined for the first time point may be reused.

In general, the optimization method or algorithm may be applied in the time domain or the frequency domain. The time domain formulation may not require a Fourier transform of the measurement values and thus may enable a faster tracking of the grid impedance and voltage variations.

According to an embodiment of the invention, entries of the error vector refer to different time points. The error vector may be composed directly of the grid current and grid voltage measurements, which may be multiplied by parameters referring to the time points of the measurements. Thus, every entry of the error vector may refer to a different measurement time point.

An objective function based on such an error vector may then be minimized in the time domain. In other words, the optimization algorithm may be directly applied to quantities, which are not transformed into the frequency domain. As already mentioned, a time domain total least square method may allow a fast tracking of the grid impedance.

According to an embodiment of the invention, the entries of the grid voltage based vector are the measurement values of the grid voltage times the grid voltage parameter. The objective function may comprise only one single parameter for the grid voltage parameter.

According to an embodiment of the invention, the entries of the grid current based vector are the measurements of the grid current times an equivalent resistance plus discrete time derivatives of the measurements of the grid currents times an equivalent inductance. The parameters of the equivalent impedance may be the equivalent resistance and the equivalent inductance.

According to an embodiment of the invention, the error vector is additionally composed of a source voltage vector, which is a source voltage matrix composed of entries of harmonic functions at different time points times a vector of amplitude parameters modelling an equivalent source voltage of the grid. The error vector may include an estimation of harmonics of the source voltage. The weighting parameters may be the source voltage parameters, which weight different frequencies of the harmonic functions. The weighting parameters may be seen as Fourier coefficients of the harmonic functions.

The frequencies of the harmonic functions may be fixed frequencies, such as multiplies of a fundamental frequency. It also may be that the frequencies are provided by another control system and/or are estimated based on the measurements of the grid voltage and/or the grid current.

According to an embodiment of the invention, an equivalent source voltage is determined by dividing the at least one source voltage parameter by the minus one times the grid voltage parameter. It has to be noted that with the method not only the equivalent impedance but also an equivalent voltage of a voltage source modelling the grid may be determined. This equivalent voltage may be determined by dividing the weighting parameters by the grid voltage parameter times the harmonic functions used in the source voltage matrix.

According to an embodiment of the invention, the error vector is multiplied with a prefactor based on the source voltage matrix, which is composed of entries of harmonic functions at different time points. The above mentioned objective function based on an error vector, which is a sum of the grid voltage based vector, the grid current based vector and the source voltage vector, which, for example, may be calculated from the source voltage matrix multiplied with the weighting vectors, may be offline analytically minimized to determine a reduced, partially optimized objective function. This may result in a prefactor that is multiplied with an error vector being only composed of the grid voltage based vector and the grid current based vector.

According to an embodiment of the invention, entries of the error vector refer to one or more different frequencies. The measurement values are transformed into the frequency domain, for example by Fourier transform, wavelets, etc. The plurality of measurement values, which have been measured in the time domain, is frequency transformed with a discrete transformation into a frequency domain.

According to an embodiment of the invention, the entries of the grid voltage based vector are the frequency transformed measurement values of the grid voltage times a complex-valued grid voltage parameter. Again, there only may be one single grid voltage parameter.

According to an embodiment of the invention, the entries of the grid current based vector are the frequency transformed measurement values of the grid current times a complex-valued equivalent impedance.

According to an embodiment of the invention, the entries of the grid voltage based vector, the grid voltage parameter, the entries of the grid current based vector, the parameters of the equivalent impedance and the at least one source voltage parameter are processed as complex values. It has to be noted that in the frequency domain, all calculations may be performed based on complex numbers. A complex representation may be used to simplify the (total) least squares algorithm for determining the optimal parameters.

According to an embodiment of the invention, the error vector is additionally composed of a source voltage vector, which is a constant vector times a complex-valued source voltage modelling an equivalent source voltage of the grid. When the calculations are performed with Fourier transform quantities, an equivalent voltage source modelling the grid may be taken into account by adding a constant factor to the Fourier transformed grid voltage. This results in a constant vector times a complex valued voltage source parameter to be added to the error vector.

According to an embodiment of the invention, the error vector is decomposed into a matrix times a vector of the grid voltage parameter and the parameters of the equivalent impedance, wherein, for taking into account an equivalent source voltage of the grid, a mean of a column of the matrix is subtracted from each column of the matrix.

The complex-valued source voltage parameter for the constant source voltage vector in the frequency domain may be offline analytically minimized, which results in an error vector as mentioned above, i.e. an error vector that is a matrix times the optimization parameters. It can be shown that the analytical optimization for the source voltage results in subtracting the mean of a column from the respective column of the matrix for every column of the matrix. According to an embodiment of the invention, a Hermitian matrix (see equation (26) below) is formed based on a measurement value matrix multiplicated with its conjugate, the measurement value matrix being composed of grid voltage measurements and grid current measurements. The objective function may be minimized by determining eigenvalues of the Hermitian matrix. The Hermitian matrix may be reduced to a 3x3 matrix and may be recursively updated by adding a correction matrix to the Hermitian matrix of the previous time step, the correction matrix being based on the grid voltage measurements and grid current measurements of a current time step.

In general, the estimated equivalent impedance can be used by protection systems, such as islanding detection, fault location, harmonics stability detection. It can also be used by the controller of numerous grid-connected electrical systems, such as active filters, electrical converters, to improve the performance of the electrical systems, in particular regarding power quality.

According to an embodiment of the invention, the method further comprises: detecting an islanding condition in the grid, when the estimated equivalent impedance leaves a defined parameter range. The estimated grid impedance may be used to detect islanding conditions. For example, an islanding condition may be detected, when a resistance of the estimated equivalent impedance becomes higher than a threshold value.

According to an embodiment of the invention, the method further comprises: estimating the fault location in the transmission and distribution network, where the grid impedance is an assumed constant input for the location methods. The estimated grid impedance can improve the location method accuracy.

According to an embodiment of the invention, the method further comprises: harmonics stability detection. Impedance based stability analysis is widely applied method for electronics based networks. The estimated harmonics impedances and harmonics voltage source can be applied to estimate the stability and resonance problems in the network.

According to an embodiment of the invention, the method further comprises: controlling a converter based on the estimated equivalent impedance and/or an estimated voltage source. It may be that an active filter connected to the electrical grid is used for filtering out harmonics from the voltage in the grid. The control method of the filter may be improved, when the estimated equivalent impedance of the grid is taken into account.

According to an embodiment of the invention, the method further comprises: adapting a current control loop of a converter system online, wherein controller parameters are adaptively calculated to achieve a specific bandwidth and damping ratio based on the estimated equivalent impedance and in particular the the estimated equivalent inductance of the grid.

A further aspect of the invention relates to a controller adapted for performing the method as described in the above and in the following. For example, the method may be implemented in software and/or may be run on a controller with a processor. However, it also may be possible that the method is at least partially implemented in hardware, for example on an FPGA or a DSP.

It has to be understood that features of the method as described in the above and in the following may be features of the controller as described in the above and in the following, and vice versa.

These and other aspects of the invention will be apparent from and elucidated with reference to the embodiments described hereinafter.

BRIEF DESCRIPTION OF THE DRAWINGS

The subject-matter of the invention will be explained in more detail in the following text with reference to exemplary embodiments which are illustrated in the attached drawings.

Fig. 1 schematically shows an electrical system with a controller according to an embodiment of the invention.

Fig. 2 shows a grid equivalent circuit used in a method for estimating an equivalent impedance of an electrical grid according to an embodiment of the invention.

Fig. 3 shows a flow diagram for a method for estimating an equivalent impedance of an electrical grid according to an embodiment of the invention.

The reference symbols used in the drawings, and their meanings, are listed in summary form in the list of reference symbols. In principle, identical parts are provided with the same reference symbols in the figures.

DETAILED DESCRIPTION OF EXEMPLARY EMBODIMENTS

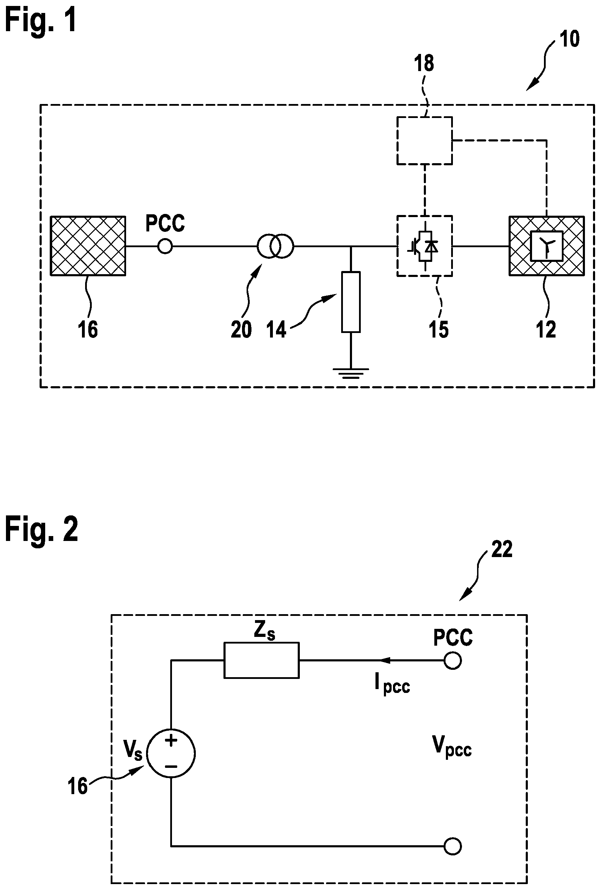

Fig.1 shows an electrical system 10, which comprises an inverter based wind turbine generator 12 with a converter system 15 that is connected via a filter system 14 and a transformer 20 to an electrical grid 16. The converter 15 may be controlled by a controller 18, which is adapted for measuring voltage and currents at a point of common coupling PCC. The converter system 15 may have adaptive current control parameters regarding the estimated grid parameters from the controller 18. The converter system 15 may also have a function as active filter, which also receive parameters from the controller 18. In a wind farm, several wind turbine generators may be connected at the PCC.

Fig. 2 shows an equivalent circuit 22 for the electrical grid 16. The equivalent circuit comprises an equivalent impedance $Z_s$ and an equivalent voltage source $V_s$. From the view of the inverter 14 and/or the wind turbine 12, the electrical grid 16 may be modelled as a voltage source $V_s$ behind the impedance Z, both at fundamental frequency and harmonic frequencies.

In general, the electrical impedance Z may be defined as the voltage to current ratio at a particular frequency $\omega$. In the linear case, the impedance at frequency $\omega$ may be calculated as

$$Z = R + j\omega L + \frac{1}{j\omega C} \tag{1}$$

where $Z$ is the impedance, $R$ is a resistance, $L$ is a reactance, $C$ is a capacitance and $\omega = 2\pi f$. In this case, it is sufficient to know the resistance and reactance at a fundamental frequency. Then, the impedance at other frequencies may be calculated accordingly.

However, with the increasing number of electronics devices connected into the electrical grid 16, nonlinearities of the electrical grid 16 may not be ignored. The impedance $Z_s$ at harmonics frequencies may not be obtained so straightforward mathematically as described with equation (1). The impedance $Z_s$ at fundamental as well as at harmonic frequencies may be influenced by controller parameters, operating points and grid conditions, etc. The impedance $Z_s$ may have to be estimated frequency by frequency, based on the voltage and current measurements at that respective frequency.

With reference to Fig. 2, the Kirchhoff's law gives

$$V_{pcc} = V_s + I_{pcc} \cdot Z_s \tag{2}$$

where $V_{pcc}$ and $I_{pcc}$ are the measured voltage and current at the point of common coupling PCC, while $V_s$ and $Z_s$ are the unknown source voltage and impedance to be estimated. If the voltage $V_s$ and equivalent impedance $Z_s$ are constant during the process of estimation and there are two measurements available, they can be written as

$$V_{pcc}^1 = V_s + I_{pcc}^1 \cdot Z_s \tag{3}$$

$$V_{pcc}^2 = V_s + I_{pcc}^2 \cdot Z_s \tag{4}$$

The impedance can be calculated as

$$Z_s = \frac{V_{pcc}^2 - V_{pcc}^1}{I_{pcc}^2 - I_{pcc}^1} \tag{5}$$

In real systems, measurements always contain additive noise $\varepsilon^k$. With $N$ measurements, equation (2) can be written as

$$\begin{bmatrix} V_{pcc}^1 \\ V_{pcc}^2 \\ ... \\ V_{pcc}^N \end{bmatrix} = V_s + \begin{bmatrix} I_{pcc}^1 \\ I_{pcc}^2 \\ ... \\ I_{pcc}^N \end{bmatrix} Z_s + \begin{bmatrix} \varepsilon^1 \\ \varepsilon^2 \\ ... \\ \varepsilon^N \end{bmatrix} \tag{5a}$$

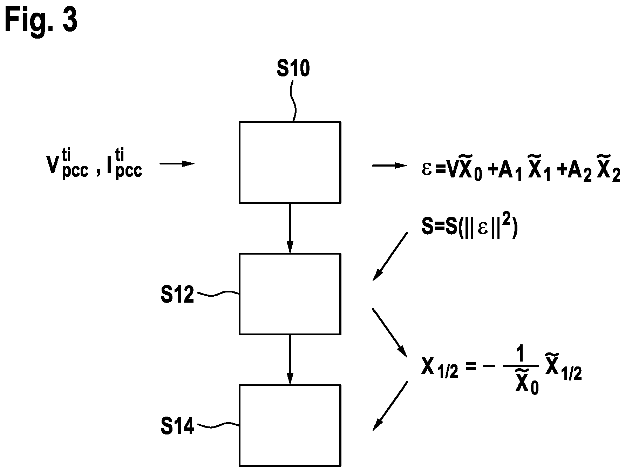

With respect to Fig. 3, in the following, a method for estimating $Z_s$ (and optionally $V_S$) from the $N$ measurements $V_{pcc}^{ti}$ and $I_{pcc}^{ti}$ is described. The method may be performed automatically by the controller (18), for example as a computer program.

In step S10, the controller receives a plurality of measurement values of the grid voltage $V_{pcc}^{ti}$ and the grid current $I_{pcc}^{ti}$, measured over a time interval at different time points $t_i$.

From these measurement values, an error vector $\varepsilon$ is generated and from this error vector, an objective function $S$ is generated.

As shown in Fig. 3, the error vector $\varepsilon$ may be composed of a grid voltage based vector $V\tilde{X}_0$ based on grid voltage measurements $V_{pcc}^{ti}$ times a grid voltage parameter $\tilde{X}_0$ and a grid current based vector $A_1\tilde{X}_1$ based on grid current measurements $I_{pcc}^{ti}$ times the parameters $\tilde{X}_1$ of the equivalent impedance. The content of the vector $V$ and the matrix $A_1$ will be described in detail below.

Optionally, the error vector $\varepsilon$ is additionally composed of a source voltage vector $A_2\tilde{X}_2$ modelling the equivalent source voltage $V_s$ of the grid 16. The source voltage vector $A_2\tilde{X}_2$ is based on at least one source voltage parameter $\tilde{X}_2$. The content of the matrix $A_2$ will be described in detail below.

For example, the objective function S may be determined directly from the error vector $\varepsilon$ by the length of the error vector $\varepsilon$. However, in the case, when the error vector $\varepsilon$ is additionally composed of the source voltage vector $A_2\tilde{X}_2$, the objective function S may have been determined from the error vector $\varepsilon$ by analytically minimizing the objective function $S$ with respect to the at least one source voltage parameter $\tilde{X}_2$, as will be described below. In this case, the objective function $S$ may depend on the sum of the grid voltage based vector $V\tilde{X}_0$ and grid current based vector $A_1\tilde{X}_1$, either multiplied with a prefactor depending on the voltage source matrix $A_2$ or with the vector $V$ and the matrix $A_1$ modified based on the entries of the voltage source matrix $A_2$.

In step S12, the controller 18 minimizes the objective function $S$, which is a function of the measurement values $V_{pcc}^{ti}$, $I_{pcc}^{ti}$, the grid voltage parameter $\tilde{X}_0$, the parameters $\tilde{X}_1$ of the equivalent impedance and optionally the at least one parameter $\tilde{X}_2$ for the equivalent voltage source. The objective function $S$ is minimized with respect to the parameters $\tilde{X}_0$, $\tilde{X}_1$ and optionally $\tilde{X}_2$. This may be performed with a total least squares algorithm.

The equivalent impedance $X_1$ is then determined by dividing the parameters of the equivalent impedance $\tilde{X}_1$ by minus one times the grid voltage parameter $\tilde{X}_0$. Optionally, the equivalent voltage source $X_2$ may be determined by dividing the at least one source voltage parameter $\tilde{X}_2$ by minus one times the grid voltage parameter $\tilde{X}_0$.

The determined/estimated equivalent impedance $X_1$ and optionally the determined/estimated equivalent voltage source $X_2$ may be used in the electrical system 10 for different purposes:

In step S14, the controller 18 detects an islanding condition in the grid 10, when the estimated equivalent impedance $\tilde{X}_1$ leaves a defined parameter range. For example, in this case, the electrical energy generation by the wind turbine may have to be shut down.

Alternately or additionally, in step S 14, the controller 18 controls the converter 15 based on the estimated equivalent impedance $\tilde{X}_1$ and/or the estimated voltage source $X_2$.

The method can be applied in both time domain and frequency domain. In the following, the exact form of the components of the error vector $\varepsilon$ in the time domain and in the frequency domain will be derived.

Time domain

In the time domain case, voltage and current measurements may be seen as direct time domain samples of the waveform of the grid voltage and the grid current. Neglecting noise, the $N$ measurements at times $t_i$ obey

$$\begin{bmatrix} V_{pcc}^{t1} \\ V_{pcc}^{t2} \\ \dots \\ V_{pcc}^{tN} \end{bmatrix} = \begin{bmatrix} V_s^{t1} \\ V_s^{t2} \\ \dots \\ V_s^{tN} \end{bmatrix} + \begin{bmatrix} I_{pcc}^{t1} \\ I_{pcc}^{t2} \\ \dots \\ I_{pcc}^{tN} \end{bmatrix} R + \begin{bmatrix} \frac{dI_{pcc}^{t1}}{dt} \\ \frac{dI_{pcc}^{t2}}{dt} \\ \dots \\ \frac{dI_{pcc}^{tN}}{dt} \end{bmatrix} L \tag{6}$$

In order to estimate the impedance, i.e. an equivalent resistance $R$ and an equivalent inductance $L$, also the source voltage $V_s^t$ may have to be estimated. $V_s^t$ may be assumed as a sine wave described by constant parameters $C_1$, $C_2$, $C_3$, $\omega$, e.g.

$$V_s^t(C_1, C_2, C_3, \omega) = C_1 \cos \omega t + C_2 \sin \omega t + C_3 \tag{7}$$

More generally, it may be assumed that the source voltage waveform comprises a fundamental component at $\omega_0$, e.g. corresponding to 50 Hz, plus $H$ harmonics at frequencies $\omega_h$. Then

$$V_s^t(C_1^0, C_2^0, C_1^h, C_2^h) = C_1^0 \cos \omega_0 t + C_2^0 \sin \omega_0 t + C_1^h \cos \omega_h t + C_2^h \sin \omega_h t \tag{8}$$

where the frequencies $\omega_0$ and $\omega_h$ are known, assumed, or estimated. (In (8) and the following, $H = 1$ is assumed for simplicity.) Then (6) can be written as:

$$\underbrace{\begin{bmatrix} V_{pcc}^{t1} \\ V_{pcc}^{t2} \\ \vdots \\ V_{pcc}^{tN} \end{bmatrix}}_{V} = \underbrace{\begin{bmatrix} I_{pcc}^{t1} & \Delta I_{pcc}^{t1}/T_S & \cos \omega_0 t_1 & \sin \omega_0 t_1 & \cos \omega_h t_1 & \sin \omega_h t_1 \\ I_{pcc}^{t2} & \Delta I_{pcc}^{t2}/T_S & \cos \omega_0 t_2 & \sin \omega_0 t_2 & \cos \omega_h t_2 & \sin \omega_h t_2 \\ \vdots & \vdots & \vdots & \vdots & \vdots & \vdots \\ I_{pcc}^{tN} & \Delta I_{pcc}^{tN}/T_S & \cos \omega_0 t_N & \sin \omega_0 t_N & \cos \omega_h t_N & \sin \omega_h t_N \end{bmatrix}}_{A} \underbrace{\begin{bmatrix} R \\ L \\ C_1^0 \\ C_2^0 \\ C_1^h \\ C_2^h \end{bmatrix}}_{X} \tag{9}$$

Equation (9) becomes

$$V = AX, \tag{10}$$

where $A$ is a 'tall' $N \times (4 + 2H)$ matrix.

As described below, it may be useful to separate the measurement parts and the known deterministic parts of the matrix $A$,

$$\underbrace{\begin{bmatrix} V_{pcc}^{t1} \\ V_{pcc}^{t2} \\ \vdots \\ V_{pcc}^{tN} \end{bmatrix}}_{V} = \underbrace{\begin{bmatrix} I_{pcc}^{t1} & \Delta I_{pcc}^{t1}/T_S \\ I_{pcc}^{t2} & \Delta I_{pcc}^{t2}/T_S \\ \vdots & \vdots \\ I_{pcc}^{tN} & \Delta I_{pcc}^{tN}/T_S \end{bmatrix}}_{A_1} \underbrace{\begin{bmatrix} R \\ L \end{bmatrix}}_{X_1} + \underbrace{\begin{bmatrix} \cos \omega_0 t_1 & \sin \omega_0 t_1 & \cos \omega_h t_1 & \sin \omega_h t_1 \\ \cos \omega_0 t_2 & \sin \omega_0 t_2 & \cos \omega_h t_2 & \sin \omega_h t_2 \\ \vdots & \vdots & \vdots & \vdots \\ \cos \omega_0 t_N & \sin \omega_0 t_N & \cos \omega_h t_N & \sin \omega_h t_N \end{bmatrix}}_{A_2} \underbrace{\begin{bmatrix} C_1^0 \\ C_2^0 \\ C_1^h \\ C_2^h \end{bmatrix}}_{X_2} \tag{11}$$

or

$$V = A_1 X_1 + A_2 X_2. \tag{12}$$

Frequency domain

The plurality of measurement values $V_{pcc}^{ti}$, $I_{pcc}^{ti}$, which have been measured in a time domain, may be transformed with a discrete transformation into a frequency domain. In particular, voltage and current measurements may be complex values obtained by a Fourier transformation at frequency $\omega = \omega_0$ or $\omega = \omega_h$. When neglecting noise

$$\underbrace{\begin{bmatrix} V_{pcc}^1 \\ V_{pcc}^2 \\ \vdots \\ V_{pcc}^N \end{bmatrix}}_{V} = \begin{bmatrix} I_{pcc}^1 \\ I_{pcc}^2 \\ \vdots \\ I_{pcc}^N \end{bmatrix} Z_s + V_s = \underbrace{\begin{bmatrix} I_{pcc}^1 & 1 \\ I_{pcc}^2 & 1 \\ \vdots & \vdots \\ I_{pcc}^N & 1 \end{bmatrix}}_{A} \underbrace{\begin{bmatrix} Z_s \\ V_s \end{bmatrix}}_{X} \tag{13}$$

Hence, this can be written in the same form as (10), although with complex matrices and vectors. Similarly to (11),

$$\underbrace{\begin{bmatrix} V_{pcc}^1 \\ V_{pcc}^2 \\ \vdots \\ V_{pcc}^N \end{bmatrix}}_{V} = \underbrace{\begin{bmatrix} I_{pcc}^1 \\ I_{pcc}^2 \\ \vdots \\ I_{pcc}^N \end{bmatrix}}_{A_1} \underbrace{Z_s}_{X_1} + \underbrace{\begin{bmatrix} 1 \\ 1 \\ \vdots \\ 1 \end{bmatrix}}_{A_2} \underbrace{V_s}_{X_2} \tag{14}$$

which has the same form as (12).

Error vector

When only noise in the voltage measurements $V_{pcc}^{ti}$ is considered, (10) becomes

$$V = AX + \varepsilon_V, \tag{15}$$

where $\varepsilon_V = [\varepsilon^1 \ldots \varepsilon^N]'$ is the vector containing the measurement noise. With a least squares method, the error

$$\varepsilon = V - AX \tag{16}$$

may be minimized. However, if there is noise also in the current measurements $I_{pcc}^{ti}$, in particular in the matrix $A$, (10) becomes

$$V + \varepsilon_V = (A + \varepsilon_A)X \tag{17}$$

and the estimation criterion becomes

$$\min_{X} S = \|\varepsilon_V, \varepsilon_A\|_F^2 \tag{18}$$

With noise both in the current and voltage measurements, the measurement model must treat voltage and current measurements symmetrically. The new approach of this invention thus models the total error as

$$\varepsilon \overset{\text{def}}{=} V\tilde{X}_0 + A\tilde{X} = \underbrace{[V\ A]}_{B} \underbrace{\begin{bmatrix} \tilde{X}_0 \\ \tilde{X} \end{bmatrix}}_{r} = V\tilde{X}_0 + A_1\tilde{X}_1 + A_2\tilde{X}_2. \tag{19}$$

where the matrix A has been split into two matrices $A_1$ and $A_2$ and the vector of optimization parameters $\tilde{X}$ has been split into the vectors $\tilde{X}_1$ and $\tilde{X}_2$ as described in the above two sections "Time domain" and "Frequency domain".

In both the time domain and the frequency domain, the error vector $\varepsilon$ is then sum of a grid voltage based vector $V\tilde{X}_0$, a grid current based vector $A_1\tilde{X}_1$ and a source voltage vector $A_2\tilde{X}_2$. As will be described below, the source voltage vector $A_2\tilde{X}_2$ may be minimized analytically (offline) and the objective function S may be evaluated online only based on the grid voltage based vector $V\tilde{X}_0$, the grid current based vector $A_1\tilde{X}_1$ and the matrix $A_2$.

In the time domain, the entries of the error vector $\varepsilon$ refer to different time points. The entries of the grid voltage based vector $V\tilde{X}_0$ are the measurement values of the grid voltage $V_{pcc}^{ti}$ times the grid voltage parameter $(\tilde{X}_0)$, see (11).

The entries of the grid current based vector $A_1\tilde{X}_1$ are the measurements of the grid current $I_{pcc}^{ti}$ times an equivalent resistance $R$ plus discrete time derivatives of the measurements $(I_{pcc}^{ti})$ of the grid currents times an equivalent inductance $L$, see (11). The source voltage vector $A_2\tilde{X}_2$ is a source voltage matrix $A_2$ composed of entries of harmonic functions at different time points times a vector $\tilde{X}_2$ of weighting parameters, see (11).

In the frequency domain, the entries of the error vector $\varepsilon$ refer to the Fourier transform at a frequency $\omega = \omega_0$ or $\omega = \omega_h$ at different times. The entries of the grid voltage based vector $V\tilde{X}_0$ are the Fourier transformed measurement values of the grid voltage $V_{pcc}^{ti}$ times a complex-valued grid voltage parameter $\tilde{X}_0$, see (14). The entries of the grid current based vector $A_1\tilde{X}_1$ are the Fourier transformed measurement values of the grid current $I_{pcc}^{ti}$ times a complex-valued equivalent impedance $Z_s$, see (14). The source voltage vector $A_2\tilde{X}_2$ is a constant vector $A_2$ (which may be seen as a matrix with one column) times a complex-valued source voltage $V_s$, see (14).

Objective function

(19) is a generalization of (16). With the introduction of the new auxiliary (scalar) parameter $\tilde{X}_0$, the voltage (in the vector $V$) is now treated symmetrically as the current (in the matrix $A$).

The parameters $\tilde{X}_0, \tilde{X}_1, \tilde{X}_2$ may be estimated with a total least squares (TLS) estimation method. Such a method may basically minimize the TLS $\|\varepsilon\|^2$ with respect to the unknown vector $r = [\tilde{X}_0, \tilde{X}_1, \tilde{X}_2]$.

To avoid a zero solution $r = 0$, the estimation criterion or objective function may be taken as

$$S = \min_{r} \frac{\|\varepsilon\|^2}{\|r\|^2} = \min_{r} \frac{r^+(B^+B)r}{\|r\|^2}. \tag{20}$$

This objective function S is a (in particular Euclidean) length of the error vector $\varepsilon$ divided by a (in particular Euclidean) length of a parameter vector, the parameter vector being composed of the grid voltage parameter $\tilde{X}_0$, the parameters $\tilde{X}_1$ of the equivalent impedance and the parameters $\tilde{X}_2$ of the voltage source.

It has to be noted that as formulated in section "time domain", the objective function S may be minimized in the time domain, and as formulated in section "frequency domain", the objective function $S$ may be minimized in the frequency domain.

The quotient in (19) may be recognized as the Rayleigh coefficient of the matrix $B^+ B$, hence the solution $r$ of (19) is the eigenvector pertaining to the smallest eigenvalue of the Hermitian matrix $B^+B$. There are numerical methods available to calculate eigenvectors and eigenvalues, hence the TLS problem may be solved to obtain the parameter vector $r$. Below, an explicit TLS method is derived and described.

Finally, the form (19) $\varepsilon \overset{\text{def}}{=} V\tilde{X}_0 + A\tilde{X}$ with the auxiliary scalar parameter $\tilde{X}_0$ must be mapped to the physically meaningful form (16) $\varepsilon = V - AX$, by

$$X = -\frac{1}{\tilde{X}_0}\tilde{X}. \tag{21}$$

In the time domain case $X$ is defined in (9), while in the frequency domain case $X$ is given in (13).

Further embodiments

In the following, modifications and refinements of the embodiment described above are provided. These modifications and refinements may be computationally more efficient and may perform better since they take advantages of the fact that a part $A_2$ of the matrix $A$ is exactly known, rather than measured. As already shown in (19), the total error is

$$\varepsilon = V\tilde{X}_0 + A_1\tilde{X}_1 + A_2\tilde{X}_2, \tag{22}$$

where $A_2$ is a known and deterministic matrix, and should therefore not be part of the measurement error model.

$\tilde{X}_2$ may be eliminated by minimizing its contribution to the total squared error by invoking the orthogonality principle $A_2^+\varepsilon = 0$. I.e., using (22),

$$A_2^+\varepsilon = A_2^+\left(V\tilde{X}_0 + A_1\tilde{X}_1 + A_2\tilde{X}_2\right) = 0. \tag{23}$$

Solving (23) for $X_2$, and inserting the result in (22) yields

$$\varepsilon = \underbrace{(I - A_2(A_2^+ A_2)^{-1}A_2^+)[V \quad A_1]}_{B}\underbrace{\begin{bmatrix}\tilde{X}_0 \\ \tilde{X}_1\end{bmatrix}}_{r}, \tag{24}$$

which has the same form as (19) with a matrix B. The error vector $\varepsilon$ comprises a prefactor based on the source voltage matrix $A_2$. Hence, the required solution $r$ is again the eigenvector pertaining to the smallest eigenvalue of the Hermitian matrix $B^+ B$.

In the time domain case (11), the matrix $A_2$ is composed of harmonic functions and has the size $N \times (2 + 2H)$. In the frequency domain case (14), $A_2$ is a one vector of size $N$, hence (24) reduces to

$$\varepsilon = \underbrace{\begin{bmatrix} V_{pcc}^1 - \overline{V_{pcc}} & I_{pcc}^1 - \overline{I_{pcc}} \\ V_{pcc}^2 - \overline{V_{pcc}} & I_{pcc}^2 - \overline{I_{pcc}} \\ \vdots & \vdots \\ V_{pcc}^N - \overline{V_{pcc}} & I_{pcc}^N - \overline{I_{pcc}} \end{bmatrix}}_{B} \underbrace{\begin{bmatrix} \tilde{X}_0 \\ \tilde{X}_1 \end{bmatrix}}_{r} \tag{25}$$

where $\overline{V_{pcc}}$ and $\overline{I_{pcc}}$ are the respective column means.

Comparing the definition of the matrix $B$ in (24) and (25) to the definition in (19), it is seen that the size of $B$ is reduced. The size of the matrix $B^+ B$ is reduced from $(5 + 2H) \times (5 + 2H)$ to $3 \times 3$ in the time domain case, and from $3 \times 3$ to $2 \times 2$ in the frequency domain case. Hence, computation of this TLS regression solution by eigenvector calculation of $B^+ B$ is more efficient.

Recursive TLS algorithm

The matrix $B$ in (19) has size $N$, where $N$ is the number of available measurements. With a direct implementation, storage and computation of $B$ would thus grow indefinitely when new measurements become available. A more efficient recursive algorithm, making use of the structure of the matrix $B = B_N$, is given by

$$\underbrace{B_k^+ B_k}_{\mathcal{B}_k} = \underbrace{B_{k-1}^+ B_{k-1}}_{\mathcal{B}_{k-1}} + \underbrace{\begin{bmatrix} V_{pcc}^{k\,*} \\ I_{pcc}^{k\,*} \\ 1 \end{bmatrix}}_{z_k} \underbrace{\begin{bmatrix} V_{pcc}^k & I_{pcc}^k & 1 \end{bmatrix}}_{z_k^+}, \tag{26}$$

$$\mathcal{B}_k = \mathcal{B}_{k-1} + z_k z_k^+. \tag{27}$$

(27) is a recursive update of the matrix $\mathcal{B}_k$, requiring only storage for a Hermitian $3 \times 3$ matrix. Its eigenvector must be calculated at each step for the TLS solution. This is numerically well possible, hence (27) gives a good recursive TLS solution.

Similarly an exponentially weighted recursive least squares algorithm (RLS), (27) can be generalised to

$$\mathcal{B}_k = \gamma \mathcal{B}_{k-1} + z_k z_k^+, \tag{28}$$

where $\gamma$ is the forgetting factor close to but smaller than 1. This modification is appropriate for tracking slowly varying parameters.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

LIST OF REFERENCE SYMBOLS

10     electrical system
12     wind turbine generator

| 14 | electrical filter |
|----|----|
| 15 | inverter |
| 16 | electrical grid |
| 18 | controller |
| 20 | transformer |
| 22 | grid model |
| PCC | point of common coupling |
| $Z_s$ | equivalent impedance |
| Vs | equivalent voltage source |

$V_{pcc}^{ti}$     grid voltage measurement value

$I_{pcc}^{ti}$     grid current measurement value

| $\varepsilon$ | error vector |
|----|----|
| $V\tilde{X}_0$ | grid voltage based vector |
| $A_1\tilde{X}_1$ | grid current based vector |
| $A_2\tilde{X}_2$ | source voltage vector |
| $\tilde{X}_0$ | grid voltage parameter |
| $\tilde{X}_1$ | equivalent impedance parameters |
| $\tilde{X}_2$ | source voltage parameter(s) |
| $S$ | objective function |
| $\tilde{X}_1$ | estimated equivalent impedance |
| $X_2$ | estimated equivalent source voltage |

**Claims**

1. A method for estimating an equivalent impedance of an electrical grid (10), the method comprising:

   receiving a plurality of measurement values of a grid voltage $(V_{pcc}^{ti})$ and a grid current $(I_{pcc}^{ti})$, measured over a time interval at different time points;

   minimizing an objective function (*S*) based on the measurement values $(V_{pcc}^{ti}, I_{pcc}^{ti})$, a grid voltage parameter ($\tilde{X}_0$), and parameters ($\tilde{X}_1$) of the equivalent impedance, which objective function (*S*) comprises a length of an error vector ($\varepsilon$); and
   determining the equivalent impedance ($X_1$) by dividing the parameters of the equivalent impedance ($\tilde{X}_1$) by the grid voltage parameter ($\tilde{X}_0$);
   wherein the error vector ($\varepsilon$) is composed of

   a grid voltage based vector ($V\tilde{X}_0$) based on grid voltage measurements $(V_{pcc}^{ti})$ times the grid voltage parameter ($\tilde{X}_0$); and

   a grid current based vector ($A_1\tilde{X}_1$) based on grid current measurements $(I_{pcc}^{ti})$ times the parameters ($\tilde{X}_1$) of the equivalent impedance.

2. The method of claim 1,
   wherein the objective function (*S*) is a length of the error vector ($\varepsilon$) divided by a length of a parameter vector, the parameter vector being composed of the grid voltage parameter ($\tilde{X}_0$) and the parameters ($\tilde{X}_1$) of the equivalent impedance.

3. The method of claim 1 or 2,
   wherein the error vector ($\varepsilon$) additionally is composed of a source voltage vector ($A_2\tilde{X}_2$) modelling an equivalent source voltage ($V_s$) of the grid (10), the source voltage vector being based on at least one source voltage parameter ($\tilde{X}_2$); and/or
   wherein the objective function (*S*) has been determined from the error vector ($\varepsilon$) by analytically minimizing the at least one source voltage parameter ($\tilde{X}_2$).

4. The method of one of the preceding claims,
   wherein the objective function ($S$) is minimized with a recursive total least squares algorithm.

5. The method of one of the preceding claims,
   wherein entries of the error vector ($\varepsilon$) refer to different time points; and/or wherein the objective function ($S$) is minimized in the time domain.

6. The method of claim 5,

   wherein the entries of the grid voltage based vector ($V\tilde{X}_0$) are the measurement values of the grid voltage $\left(V_{pcc}^{ti}\right)$ times the grid voltage parameter ($\tilde{X}_0$); and/or

   wherein the entries of the grid current based vector ($A_1\tilde{X}_1$) are the measurements of the grid current $\left(I_{pcc}^{ti}\right)$, times an equivalent resistance plus discrete time derivatives of the measurements $\left(I_{pcc}^{ti}\right)$ of the grid currents times an equivalent inductance.

7. The method of claim 5 or 6,
   wherein the error vector ($\varepsilon$) is additionally composed of a source voltage vector ($A_2\tilde{X}_2$), which is a source voltage matrix composed of entries of harmonic functions at different time points times a vector of weighting parameters ($\tilde{X}_2$) modelling an equivalent source voltage of the grid (10).

8. The method of one of claims 5 to 6,
   wherein the error vector ($\varepsilon$) is additionally based on a source voltage matrix composed of entries of harmonic functions at different time points;
   wherein the error vector ($\varepsilon$) is multiplied with a prefactor based on the source voltage matrix.

9. The method of one of claims 1 to 3,
   wherein entries of the error vector ($\varepsilon$) refer to one or more given frequencies;; and/or

   wherein the plurality of measurement values $\left(V_{pcc}^{ti}, I_{pcc}^{ti}\right),$ which have been measured in a time domain, are transformed with a discrete transformation into a frequency domain.

10. The method of claim 9,
    wherein the entries of the grid voltage based vector ($V\tilde{X}_0$) are the frequency transformed measurement values of the grid voltage $\left(V_{pcc}^{ti}\right)$ times a complex-valued grid voltage parameter ($\tilde{X}_0$);
    wherein the entries of the grid current based vector ($A_1\tilde{X}_1$) are the frequency transformed measurement values of the grid current $\left(I_{pcc}^{ti}\right)$ times a complex-valued equivalent impedance.

11. The method of claim 9 or 10,
    wherein the error vector ($\varepsilon$) is additionally composed of a source voltage vector ($A_2\tilde{X}_2$), which is a constant vector times a complex-valued source voltage modelling an equivalent source voltage of the grid.

12. The method of claim 9 or 10,
    wherein the error vector ($\varepsilon$) is decomposed into a matrix times a vector of the grid voltage parameter ($\tilde{X}_0$) and the parameters ($\tilde{X}_1$) of the equivalent impedance;
    wherein, for taking into account an equivalent source voltage of the grid (10), a mean of a column of the matrix is subtracted from each column of the matrix.

13. The method of one of the preceding claims,

wherein a Hermitian matrix $(B_k^+ B_k)$ is formed based on a measurement value matrix ($B=[V, A_1, A_2]$) multiplicated with its conjugate, the measurement value matrix being composed of grid voltage measurements $(V_{pcc}^{ti})$ and grid current measurements $(I_{pcc}^{ti})$ and wherein the objective function ($S$) is minimized by determining eigenvalues of the Hermitian matrix;

wherein the Hermitian matrix is recursively updated by adding a correction matrix to the Hermitian matrix of the previous time step, the correction matrix being based on the grid voltage measurements $(V_{pcc}^{ti})$ and grid current measurements $(I_{pcc}^{ti})$ of a current time step.

14. The method of one of the preceding claims, further comprising:

detecting an islanding condition in the grid (10), when the estimated equivalent impedance ($X_1$) leaves a defined parameter range; and/or

controlling a converter system (15) based on the estimated equivalent impedance ($X_1$) and/or an estimated voltage source ($X_2$); and/or

adapting a current control loop of a converter system (15) online, wherein controller parameters are adaptively calculated to achieve a specific bandwidth and damping ratio based on the estimated equivalent impedance ($X_1$).

15. A controller (18) adapted for performing the method of one of the preceding claims.

# Fig. 1

# Fig. 2

**Fig. 3**

S10

$V_{pcc}^{ti} , I_{pcc}^{ti} \longrightarrow$

$\varepsilon = V\widetilde{X}_0 + A_1 \widetilde{X}_1 + A_2 \widetilde{X}_2$

$S = S(\| \varepsilon \|^2)$

S12

$X_{1/2} = - \dfrac{1}{\widetilde{X}_0} \widetilde{X}_{1/2}$

S14

Europäisches
Patentamt

European
Patent Office

Office européen
des brevets

# EUROPEAN SEARCH REPORT

Application Number

EP 17 15 5324

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | COBRECES S ET AL: "Grid Impedance Monitoring System for Distributed Power Generation Electronic Interfaces", IEEE TRANSACTIONS ON INSTRUMENTATION AND MEASUREMENT, IEEE SERVICE CENTER, PISCATAWAY, NJ, US, vol. 58, no. 9, 1 September 2009 (2009-09-01), pages 3112-3121, XP011269404, ISSN: 0018-9456, DOI: 10.1109/TIM.2009.2016883 * abstract * * page 3113, left-hand column, paragraph 5th - page 3115, right-hand column, paragraph 2nd; figures 1-5 * | 1-15 | INV. G01R27/16 G01R31/42 G01R31/34 G01R19/25 G01R31/08 |
| X | BABAZADEH DAVOOD ET AL: "Short circuit capacity estimation for HVDC control application", 2016 POWER SYSTEMS COMPUTATION CONFERENCE (PSCC), POWER SYSTEMS COMPUTATION CONFERENCE, 20 June 2016 (2016-06-20), pages 1-7, XP032944054, DOI: 10.1109/PSCC.2016.7540875 [retrieved on 2016-08-10] * abstract * * page 2, right-hand column, paragraph 2nd - page 3, right-hand column, paragraph 1st; figures 1, 2 * | 1-15 | |

TECHNICAL FIELDS
SEARCHED      (IPC)

G01R

-/--

The present search report has been drawn up for all claims

| Place of search | Date of completion of the search | Examiner |
|---|---|---|
| Munich | 9 August 2017 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 9

Europäisches
Patentamt

European
Patent Office

Office européen
des brevets

## EUROPEAN SEARCH REPORT

Application Number

EP 17 15 5324

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BORKOWSKI DARIUSZ: "Power system impedance tracking using sliding, finite memory complex recursive least squares", 2013 SIGNAL PROCESSING: ALGORITHMS, ARCHITECTURES, ARRANGEMENTS, AND APPLICATIONS (SPA), POZNAN UNIV OF TECHNOLOGY, 26 September 2013 (2013-09-26), pages 78-81, XP032550275, ISSN: 2326-0262 [retrieved on 2014-01-13] * abstract * * page 78, right-hand column, paragraph 1st - page 81, left-hand column, last paragraph * ----- | 1-15 | |
| X | Md. Umar Hashmi ET AL: "Online Thevenin Equivalent Parameter Estimation using Nonlinear and Linear Recursive Least Square Algorithm", , 20 July 2016 (2016-07-20), XP055330158, Retrieved from the Internet: URL:https://arxiv.org/ftp/arxiv/papers/1610/1610.05142.pdf * abstract * * page 2, right-hand column, last paragraph - page 4, left-hand column, paragraph 1st; figures 4-7 * ----- -/-- | 1-15 | TECHNICAL FIELDS SEARCHED (IPC) |

The present search report has been drawn up for all claims

| Place of search | Date of completion of the search | Examiner |
|---|---|---|
| Munich | 9 August 2017 | Bergado Colina, J |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

## EUROPEAN SEARCH REPORT

Application Number

EP 17 15 5324

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | COBRECES S ET AL: "Complex-space recursive least squares power system identification", POWER ELECTRONICS SPECIALISTS CONFERENCE, 2007. PESC 2007. IEEE, IEEE, PISCATAWAY, NJ, USA, 17 June 2007 (2007-06-17), pages 2478-2484, XP031218653, ISBN: 978-1-4244-0654-8 * the whole document * | 1-15 | |
| X | RITZMANN DEBORAH ET AL: "A Method for Accurate Transmission Line Impedance Parameter Estimation", IEEE TRANSACTIONS ON INSTRUMENTATION AND MEASUREMENT, IEEE SERVICE CENTER, PISCATAWAY, NJ, US, vol. 65, no. 10, 1 October 2016 (2016-10-01), pages 2204-2213, XP011622711, ISSN: 0018-9456, DOI: 10.1109/TIM.2016.2556920 [retrieved on 2016-09-12] * the whole document * | 1-15 | |
| X | RITZMANN DEBORAH ET AL: "Improving the accuracy of synchrophasor-based overhead line impedance measurement", 2015 IEEE INTERNATIONAL WORKSHOP ON APPLIED MEASUREMENTS FOR POWER SYSTEMS (AMPS), IEEE, 23 September 2015 (2015-09-23), XP032809603, DOI: 10.1109/AMPS.2015.7312751 [retrieved on 2015-10-29] * the whole document * | 1-15 | |

-/--

TECHNICAL FIELDS
SEARCHED      (IPC)

The present search report has been drawn up for all claims

| Place of search | Date of completion of the search | Examiner |
|---|---|---|
| Munich | 9 August 2017 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 17 15 5324

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SAINZ LUIS ET AL: "Effect of wind turbine converter control on wind power plant harmonic response and resonances", IET ELECTRIC POWER APPLICAT, IET, UK, vol. 11, no. 2, 1 February 2017 (2017-02-01), pages 157-168, XP006060234, ISSN: 1751-8660, DOI: 10.1049/IET-EPA.2016.0241 * the whole document * | 1-15 | |
| A | HE LINA ET AL: "Parameter Identification With PMUs for Instability Detection in Power Systems With HVDC Integrated Offshore Wind Energy", IEEE TRANSACTIONS ON POWER SYSTEMS, IEEE SERVICE CENTER, PISCATAWAY, NJ, US, vol. 29, no. 2, 1 March 2014 (2014-03-01), pages 775-784, XP011540098, ISSN: 0885-8950, DOI: 10.1109/TPWRS.2013.2283656 [retrieved on 2014-02-14] * the whole document * | 1-15 | |
| A | GRYNING MIKKEL P S ET AL: "Wind Turbine Inverter Robust Loop-Shaping Control Subject to Grid Interaction Effects", IEEE TRANSACTIONS ON SUSTAINABLE ENERGY, IEEE, USA, vol. 7, no. 1, 1 January 2016 (2016-01-01), pages 41-50, XP011594218, ISSN: 1949-3029, DOI: 10.1109/TSTE.2015.2472285 [retrieved on 2015-12-14] * the whole document * | 1-15 | TECHNICAL FIELDS SEARCHED (IPC) |

-/--

The present search report has been drawn up for all claims

| Place of search | Date of completion of the search | Examiner |
|---|---|---|
| Munich | 9 August 2017 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 17 15 5324

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YONG LI ET AL: "Realization of Reactive Power Compensation Near the LCC-HVDC Converter Bridges by Means of an Inductive Filtering Method", IEEE TRANSACTIONS ON POWER ELECTRONICS, INSTITUTE OF ELECTRICAL AND ELECTRONICS ENGINEERS, USA, vol. 27, no. 9, 1 September 2012 (2012-09-01), pages 3908-3923, XP011454763, ISSN: 0885-8993, DOI: 10.1109/TPEL.2012.2189587 * the whole document * | 1-15 | |
| A | SHUAI ZHIKANG ET AL: "Series and Parallel Resonance Problem of Wideband Frequency Harmonic and Its Elimination Strategy", IEEE TRANSACTIONS ON POWER ELECTRONICS, INSTITUTE OF ELECTRICAL AND ELECTRONICS ENGINEERS, USA, vol. 29, no. 4, 1 April 2014 (2014-04-01), pages 1941-1952, XP011529967, ISSN: 0885-8993, DOI: 10.1109/TPEL.2013.2264840 [retrieved on 2013-10-15] * the whole document * | 1-15 | TECHNICAL FIELDS SEARCHED (IPC) |

-/--

The present search report has been drawn up for all claims

| Place of search | Date of completion of the search | Examiner |
|---|---|---|
| Munich | 9 August 2017 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 361 272 A1**

Europäisches Patentamt
European Patent Office
Office européen des brevets

# EUROPEAN SEARCH REPORT

Application Number

EP 17 15 5324

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MOALLEM A ET AL: "Frequency domain identification of the utility grid parameters for distributed power generation systems", APPLIED POWER ELECTRONICS CONFERENCE AND EXPOSITION (APEC), 2011 TWENTY-SIXTH ANNUAL IEEE, IEEE, 6 March 2011 (2011-03-06), pages 965-969, XP032013995, DOI: 10.1109/APEC.2011.5744711 ISBN: 978-1-4244-8084-5 * the whole document * | 1-15 | |
| A | LI HAIQING ET AL: "Effects of different control strategies of distributed generation on the equivalent output impedance of the grid-connected inverter", 2014 16TH INTERNATIONAL CONFERENCE ON HARMONICS AND QUALITY OF POWER (ICHQP), IEEE, 25 May 2014 (2014-05-25), pages 664-668, XP032611556, DOI: 10.1109/ICHQP.2014.6842854 [retrieved on 2014-06-24] * the whole document * | 1-15 | |
| A | HE JINWEI ET AL: "An Enhanced Islanding Microgrid Reactive Power, Imbalance Power, and Harmonic Power Sharing Scheme", IEEE TRANSACTIONS ON POWER ELECTRONICS, INSTITUTE OF ELECTRICAL AND ELECTRONICS ENGINEERS, USA, vol. 30, no. 6, 1 June 2015 (2015-06-01), pages 3389-3401, XP011570299, ISSN: 0885-8993, DOI: 10.1109/TPEL.2014.2332998 [retrieved on 2015-01-16] * the whole document * | 1-15 | |

TECHNICAL FIELDS
SEARCHED      (IPC)

-/--

The present search report has been drawn up for all claims

| Place of search | Date of completion of the search | Examiner |
|---|---|---|
| Munich | 9 August 2017 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 6 of 9

23

Europäisches
Patentamt

European
Patent Office

Office européen
des brevets

## EUROPEAN SEARCH REPORT

Application Number

EP 17 15 5324

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JINWEI HE ET AL: "An Islanding Microgrid Power Sharing Approach Using Enhanced Virtual Impedance Control Scheme", IEEE TRANSACTIONS ON POWER ELECTRONICS, INSTITUTE OF ELECTRICAL AND ELECTRONICS ENGINEERS, USA, vol. 28, no. 11, 1 November 2013 (2013-11-01), pages 5272-5282, XP011509205, ISSN: 0885-8993, DOI: 10.1109/TPEL.2013.2243757 * the whole document * | 1-15 | |
| A | US 2013/148394 A1 (O'BRIEN KATHLEEN ANN [US] ET AL) 13 June 2013 (2013-06-13) * abstract * * paragraph [[0014]] - paragraph [[0040]]; figures 1-4 * | 1-15 | |
| A | US 2010/085065 A1 (RYLANDER MATTHEW ROBERT [US] ET AL) 8 April 2010 (2010-04-08) * abstract * * paragraph [[0027]] - paragraph [[0076]]; figures 1-14 * | 1-15 | TECHNICAL FIELDS SEARCHED (IPC) |
| A | US 2013/250635 A1 (SIVAKUMAR SESHADRI [US] ET AL) 26 September 2013 (2013-09-26) * abstract * * paragraph [[0021]] - paragraph [[0076]]; figures 1-11 * | 1-15 | |
| A | CN 103 308 806 B (UNIV JIANGSU) 8 July 2015 (2015-07-08) * the whole document * | 1-15 | |

-/--

The present search report has been drawn up for all claims

| Place of search | Date of completion of the search | Examiner |
|---|---|---|
| Munich | 9 August 2017 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 17 15 5324

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2014/152292 A1 (ANDRESEN BJÖRN [DK] ET AL) 5 June 2014 (2014-06-05)<br>* abstract *<br>* paragraph [[0063]] - paragraph [[0083]]; figures 1-6 * | 1-15 | |
| A | EP 2 738 905 A2 (GEN ELECTRIC [US]) 4 June 2014 (2014-06-04)<br>* abstract *<br>* paragraph [[0021]] - paragraph [[0046]]; figures 1-5 * | 1-15 | |
| A | WO 2011/091441 A1 (GENEVA CLEANTECH INC [US]; RADA PATRICK A [US]; MAGNASCO JOHN H [US]) 28 July 2011 (2011-07-28)<br>* abstract *<br>* page 32, last paragraph - page 47, paragraph first; figures 10-14 * | 1-15 | |
| A | WO 2017/000740 A1 (HUAWEI TECH CO LTD [CN]) 5 January 2017 (2017-01-05)<br>* the whole document * | 1-15 | TECHNICAL FIELDS SEARCHED (IPC) |
| A | CN 102 332 723 B (UNIV HUNAN) 9 April 2014 (2014-04-09)<br>* the whole document * | 1-15 | |

-/--

The present search report has been drawn up for all claims

| Place of search | Date of completion of the search | Examiner |
|---|---|---|
| Munich | 9 August 2017 | Bergado Colina, J |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...............................................
& : member of the same patent family, corresponding
    document

EPO FORM 1503 03.82 (P04C01)

Europäisches
Patentamt

European
Patent Office

Office européen
des brevets

# EUROPEAN SEARCH REPORT

Application Number

EP 17 15 5324

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | Deborah Ritzmann ET AL: "APPLICATION AND ANALYSIS OF SYNCHROPHASOR-BASED ONLINE IMPEDANCE MEASUREMENT METHODS", 23rd International Conference on Electricity Distribution, Paper 0834, 18 June 2015 (2015-06-18), pages 1-5, XP055396792, Lyon, 15-18 June 2015 Retrieved from the Internet: URL:https://www.researchgate.net/profile/Deborah_Ritzmann/publication/281935825_APPLICATION_AND_ANALYSIS_OF_SYNCHROPHASOR-BASED_ONLINE_IMPEDANCE_MEASUREMENT_METHODS/links/55fecc2d08aec948c4f5d2db.pdf [retrieved on 2017-08-08] * the whole document * | 1-15 | |

----- 

TECHNICAL FIELDS
SEARCHED (IPC)

The present search report has been drawn up for all claims

| Place of search | Date of completion of the search | Examiner |
|---|---|---|
| Munich | 9 August 2017 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 15 5324

This annex lists the patent family members relating to the patent documents cited in the above-mentioned European search report.
The members are as contained in the European Patent Office EDP file on
The European Patent Office is in no way liable for these particulars which are merely given for the purpose of information.

09-08-2017

| Patent document cited in search report | | Publication date | Patent family member(s) | | Publication date |
|---|---|---|---|---|---|
| US 2013148394 | A1 | 13-06-2013 | US 2013148394 A1 | | 13-06-2013 |
| | | | WO 2013090587 A1 | | 20-06-2013 |
| US 2010085065 | A1 | 08-04-2010 | NONE | | |
| US 2013250635 | A1 | 26-09-2013 | AU 2012374044 A1 | | 02-10-2014 |
| | | | CL 2014002501 A1 | | 11-09-2015 |
| | | | CN 104718680 A | | 17-06-2015 |
| | | | JP 6140803 B2 | | 31-05-2017 |
| | | | JP 2015520592 A | | 16-07-2015 |
| | | | MX 337709 B | | 15-03-2016 |
| | | | US 2013250635 A1 | | 26-09-2013 |
| | | | US 2016344191 A1 | | 24-11-2016 |
| | | | WO 2013141908 A2 | | 26-09-2013 |
| CN 103308806 | B | 08-07-2015 | NONE | | |
| US 2014152292 | A1 | 05-06-2014 | CN 103154760 A | | 12-06-2013 |
| | | | EP 2630510 A1 | | 28-08-2013 |
| | | | US 2014152292 A1 | | 05-06-2014 |
| | | | WO 2012052190 A1 | | 26-04-2012 |
| EP 2738905 | A2 | 04-06-2014 | CA 2833953 A1 | | 30-05-2014 |
| | | | EP 2738905 A2 | | 04-06-2014 |
| | | | US 2014152331 A1 | | 05-06-2014 |
| WO 2011091441 | A1 | 28-07-2011 | CN 102822639 A | | 12-12-2012 |
| | | | CN 102823123 A | | 12-12-2012 |
| | | | EP 2529190 A1 | | 05-12-2012 |
| | | | EP 2529473 A1 | | 05-12-2012 |
| | | | JP 5865842 B2 | | 17-02-2016 |
| | | | JP 2013518347 A | | 20-05-2013 |
| | | | JP 2013518556 A | | 20-05-2013 |
| | | | JP 2016140239 A | | 04-08-2016 |
| | | | KR 20120118049 A | | 25-10-2012 |
| | | | KR 20120138753 A | | 26-12-2012 |
| | | | WO 2011091441 A1 | | 28-07-2011 |
| | | | WO 2011091444 A1 | | 28-07-2011 |
| WO 2017000740 | A1 | 05-01-2017 | CN 106329563 A | | 11-01-2017 |
| | | | WO 2017000740 A1 | | 05-01-2017 |
| CN 102332723 | B | 09-04-2014 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. RITZMANN ; P. WRIGHT ; W. HOLDERBAUM ; B. POTTER.** Application and Analysis of Synchrophasor-based Online Impedance Measurement Methods. *CIRED, 23rd International Conference on Electricity Distribution,* 15 June 2015